(19) Europäisches Patentamt
European Patent Office
Office européen des brevets

(11) Publication number: 0 146 811
A2

# (12) EUROPEAN PATENT APPLICATION

(21) Application number: 84114417.3

(22) Date of filing: 28.11.84

(51) Int. Cl.[4]: C 08 G 73/20
H 01 L 23/30, H 01 B 3/30

(30) Priority: 29.11.83 US 556022

(43) Date of publication of application:
03.07.85 Bulletin 85/27

(84) Designated Contracting States:
BE DE FR GB IT

(71) Applicant: PHILIP A. HUNT CHEMICAL CORP.
Palisades Park New Jersey 07650(US)

(72) Inventor: Cordes, William Frederick, III
396 Cedar Avenue
East Greenwich Rhode Island 02818(US)

(72) Inventor: Jeffries, Alfred, T. III
1 Potter Drive
Providence Rhode Island 02907(US)

(74) Representative: Vossius Vossius Tauchner Heunemann Rauh
Siebertstrasse 4 P.O. Box 86 07 67
D-8000 München 86(DE)

## (54) High-temperature films and coating solutions for use in the manufacture of semi-conductor integrated circuits.

(57) A coating solution is provided for use in forming planar, thermally stable, dielectric films having a low mobile ion content and good planarizing properties. The solution contains a specific, uncured poly(imidazopyrrolone-imide) copolymer dissolved in a polar organic solvent such as, for example, 1-methyl-2-pyrrolidinone, N,N-dimethylacetamide, N,N-dimethylformamide, or dimethylsulfoxide, and has a solids content of from about 5 to about 40%, a solution viscosity of from about 0.2 to 3.5 Pa·s, a sodium ion content of less than about 5 ppm, and a maximum particle size of about 0.2 micron. The solution may also contain a diluent, such as, for example, super highflash naphtha, toluene, or xylene. Also provided are films formed from the cured poly(imidazopyrrolone-imide) copolymer and semiconductor devices including these films.

EP 0 146 811 A2

Croydon Printing Company Ltd.

HIGH-TEMPERATURE FILMS AND COATING SOLUTIONS FOR USE IN THE MANUFACTURE OF SEMI-CONDUCTOR INTEGRATED CIRCUITS

The present invention relates to semi-conductor devices. More particularly, the present invention relates to coating solutions containing a poly(imidazopyrrolone-imide) copolymer, to a method of making planar, thermally stable high-temperature dielectric films from such solutions, to the resultant films, and to semi-conductor intergrated circuits containing such films.

In the manufacture of semi-conductor integrated circuits, especially monolithic integrated circuits, a conductor metal, such as aluminum, tungsten, or titanium, is evaporated onto a silicon wafer containing at least one semi-conductor element such as a transistor, in a predetermined interconnection pattern to form a first interconnection conductor layer. The metal is removed from areas not on the pattern by well known photolithographic techniques.

In order to construct additional interconnection conductor layers on the wafer, a passivating film or layer is provided on the first interconnection conductor layer and then the next interconnection conductor layer is provided on top of the

passivating layer. The interconnection conductor layers are electrically connected through holes located at predetermined positions in the passivating layer. One such passivating film employed in the art is a $SiO_2$ film which is deposited by chemical vapor deposition, RF-sputtering or a similar such process. The use of $SiO_2$ films, however, is not without certain problems. It is difficult to obtain a thick $SiO_2$ layer because of the formation of cracks or pinholes which can, for example, short circuit the conductor layers on either side of the $SiO_2$ passivating layer.

In order to overcome these disadvantages, polyimide resin films have been employed in conjunction with the $SiO_2$ layer, sometimes with an intermediate layer of a metal oxide, such as aluminum oxide, between the resin layer and the $SiO_2$ layer, or have been used as a substitute for sputtered $SiO_2$. The polyimides are generally employed in conjunction with adhesion promoters. In the manufacture of semiconductor devices employing polyimide films, an adhesion promoter is typically applied to the wafer on a spin table followed by application of the polyimide with the speed at which the wafer is spun being selected according to the film thickness desired. The polyimide film is then cured before the next conductor layer is applied.

In the use of such resin films, it is desirable to planarize the surface in order to smooth the edges to improve coverage with the subsequent metal layer, and because exposure of images from a mask is more uniform if differences in heights are reduced across the wafer surface. The degree of planarization is determined by the ratio of the step height resulting from application of the polyimide film to the initial step height of the metal pattern.

The degree of planarization is also affected by the slope of the resulting step.

Polymers used in the semiconductor industry should exhibit a resistance to temperature at about 500°C because the aluminum ohmic contacts must be sintered for about 15 minutes at about 500°C, and should have a low mobile ion content. Positively charged mobile ions create instability in metal oxide silicon semi-conductor (MOS) devices because they accumulate near the silicon surface as a result of electric fields produced when positive voltage is placed on the interconnection patterns. These ions induce an equal-image charge within the silicon which may actually invert the n-type silicon to p-type.

Accordingly, the present invention provides coating solutions for use in forming planar films which exhibit the high temperature resistance required for use in the manufacture of semiconductor devices and which have a low mobile ion content.

The present invention relates to coating solutions for use in forming planar, thermally stable, insulating films having a low mobile ion content, which are preferably used as a passivating layer between adjacent interconnection conductor layers in the manufacture of semi-conductor integrated circuits. The coating solutions contain a specific, uncured poly(imidazopyrrolone-imide) copolymer in a polar organic solvent such as, for example, 1-methyl-2-pyrrolidinone, N,N-dimethylacetamide, N,N-dimethylformamide, dimethylsulfoxide, or a mixture thereof, at a solids content of from about 5 to about 40%. The coating solutions have a solution viscosity of from about 0.2 to 3.5 Pa·s (about 200 to 3500 cps) at 25°C, a sodium ion content of less than about 5 ppm, and a maximum particle size of about

0.2 micron. In conjunction with the polar organic solvent, the solution may also contain a diluent such as, for example, super highflash naphtha, toluene, xylene, or mixtures thereof.

The present invention also contemplates within its scope, films formed from the poly(imidazopyrrolone-imide) copolymer, a method of making these films, and multi-layer semi-conductor integrated circuits containing a plurality of interconnection conductor layers in which adjacent conductor layers are separated by a passivating layer of the film. In addition, the uncured or partially cured films of the present invention can be overcoated with a photoresist, exposed, and developed to yield a patterned multilayer structure. The films of the present invention formed from the cured copolymer are characterized by a sodium ion content of less than about 5 ppm, a degree of planarization of from about 0.3 to about 0.8, and an electrical resistance of from about $10^{12}$ to about $10^{16}$ ohm-cm.

The coating solutions of the present invention contain a specific, uncured poly(imidazopyrrolone-imide) copolymer in a polar organic solvent. The uncured poly(imidazopyrrolone-imide) copolymer is the reaction product of (A) a tetracarboxylic compound selected from the group consisting of

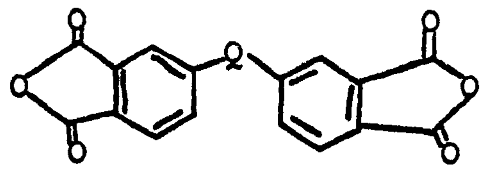

,

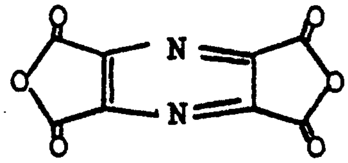

,

and mixtures thereof; (B) an aromatic tetraamine compound having the following formula:

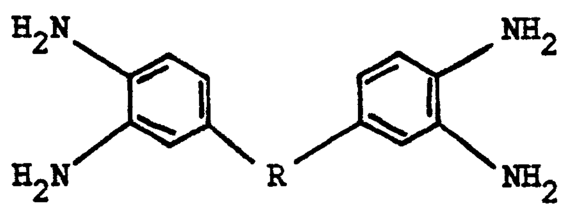

;

and (C) a diamine compound selected from the group consisting of

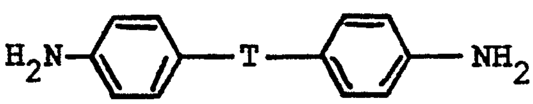

,

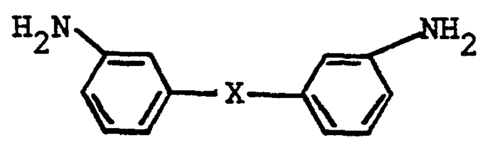

,

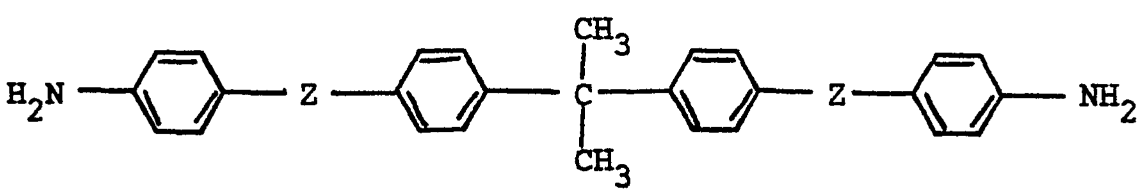

,

and mixtures thereof, wherein Q and R are, independently, a direct bond, -O-, -CO- -S-, $-SO_2-$, or $-NCH_3-$; T is a direct bond, -O-, -S-, -SO-, $-SO_2-$, or $-NCH_3-$; and X and Z are, independently, a direct bond, -O-, -CO-,

-S-, -SO-, $-SO_2-$, or $-NCH_3-$; and is believed to consist of units of the formula:

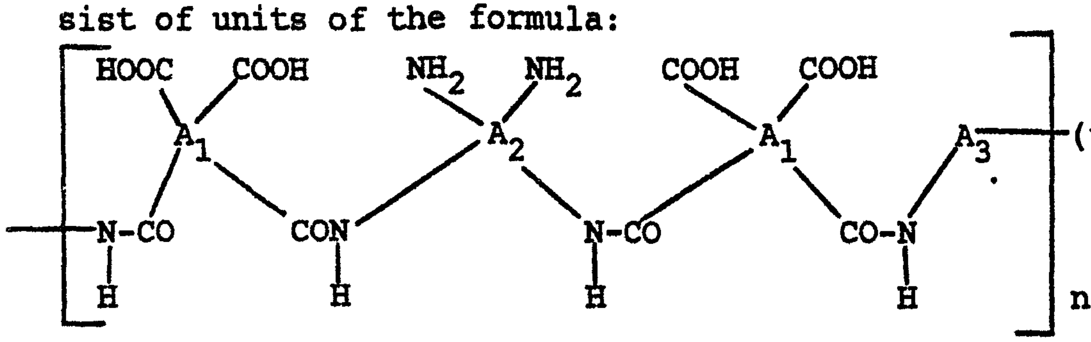

(uncured form), I

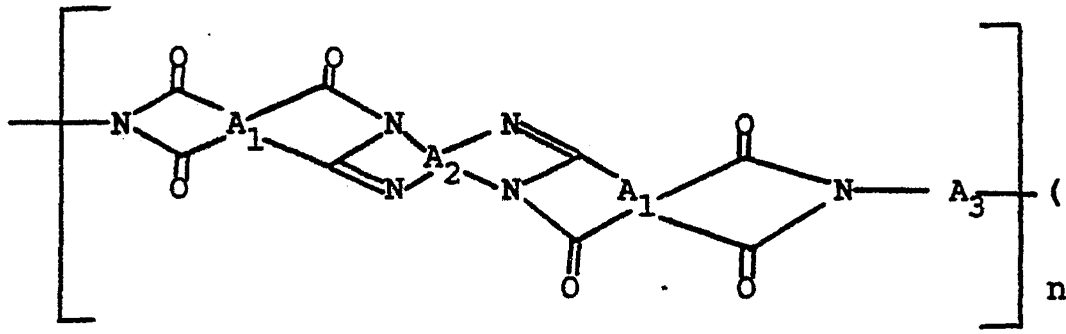

(cured form), II

wherein $A_1$ and $A_2$ represent, independently, tetravalent phenyl, or

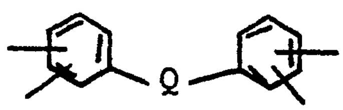

,

$A_3$ represents 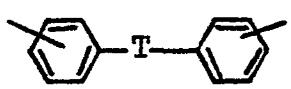 , and

Q and T have their previously assigned meanings. The uncured copolymer has an inherent viscosity of at least 0.1 dl/g as a 0.1 g in 20 ml solution in 1-methyl-2-pyrrolidinone (NMP) at 25°C. Preferably, the sum of the molar amounts of aromatic tetraamine and diamine compounds employed equals the molar amount of tetracarboxylic compound used.

Preferred poly(imidazopyrrolone-imide) copolymers are the reaction products of 3,3',4,4'-benzophenonetetracarboxylicdianhydride (BTDA), 3,3',4,4'-tetraaminobiphenyl (TAB), and 4,4'-oxydianiline (ODA), which are believed to consist of units of the formula:

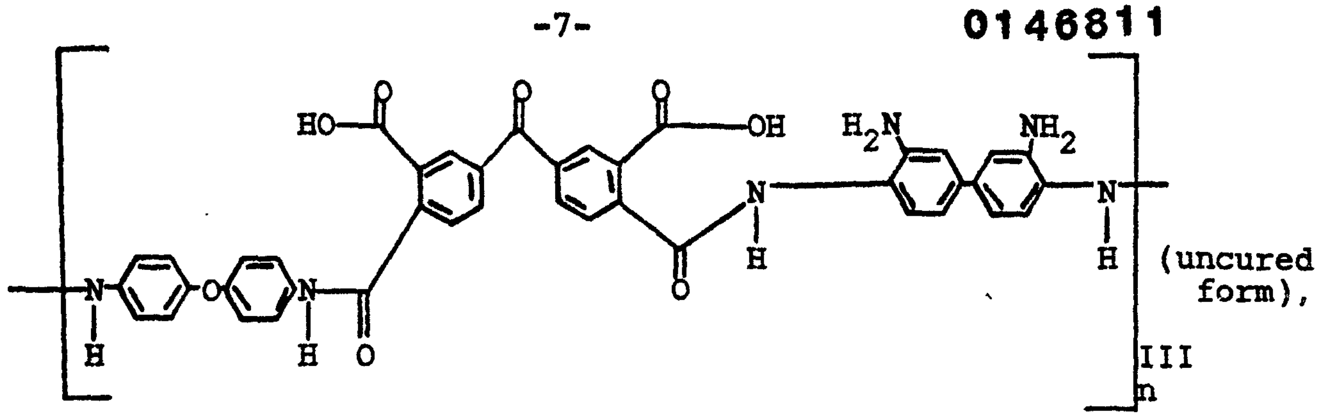

(uncured form),

III

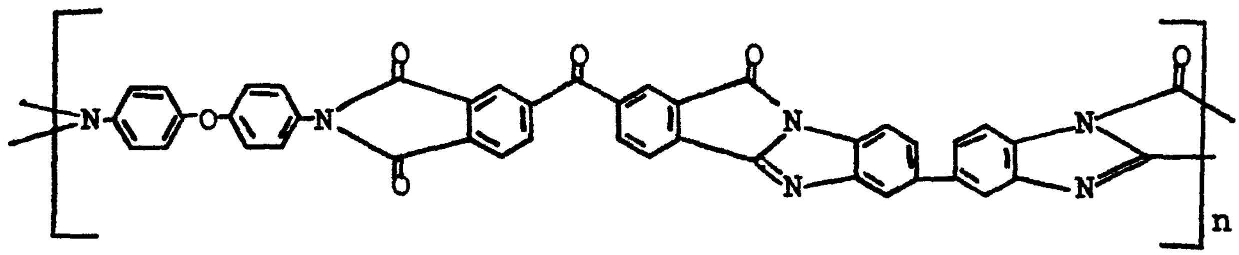

(cured form),

IV

although the exact structure is not known. The uncured copolymer has an inherent viscosity of at least about 0.1 dl/g as a 0.5% solution in NMP at 25°C. The amounts of ODA and TAB useful in forming the preferred copolymers of the present invention range, respectively, from about 75% to about 90% ODA and from about 25% to about 10% TAB by weight of the ODA and TAB. The sum of the molar amounts of ODA and TAB employed equals the molar amount of BTDA used.

Poly(imidazopyrrolone-imide) copolymers are readily prepared according to methods known to those skilled in the art as evidenced by V. L. Bell, "Preparation and Properties Of Imide-Pyrrone Copolymers," J. Applied Polymer Sci., 14, 2385-98 (1970).

The polymers of formulae I and II can be prepared as follows:

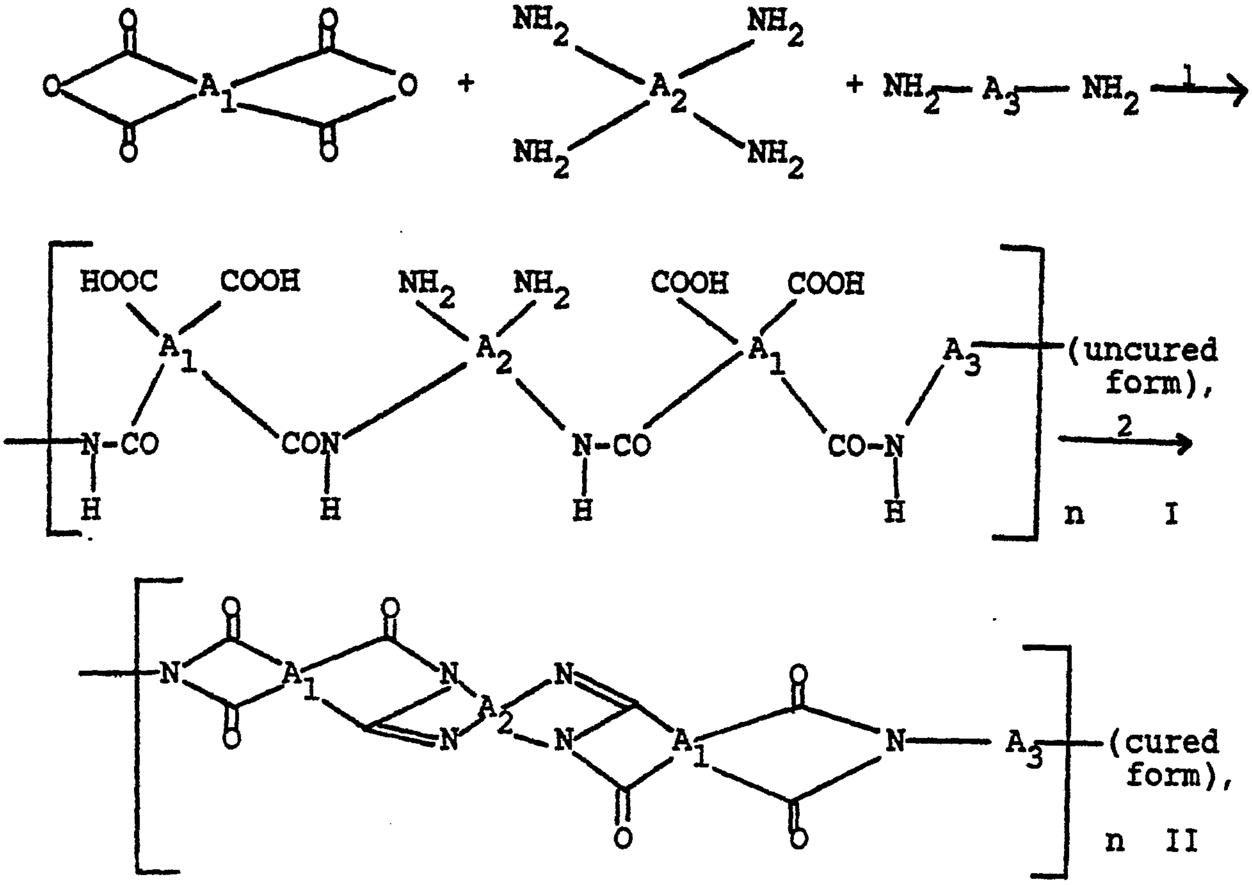


wherein $A_1$, $A_2$, and $A_3$ have their previously assigned meanings. The molar amounts of $A_2$ and $A_3$ are varied in the initial reaction mixture so that their sum is approximately equal to the molar amount of $A_1$. Reaction 1 is carried out in solution in a polar organic solvent, preferably selected from the group consisting of 1-methyl-2-pyrrolidinone (NMP), N,N-dimethylacetamide (DMAC), N,N-dimethylformamide, dimethylsulfoxide, and mixtures thereof. Preferably, the solvent is NMP or DMAC. The copolymer (I) may be isolated as a solid or it may remain in solution with one or a mixture of the above-mentioned polar solvents. The solution may be diluted with an aromatic hydrocarbon solvent preferably selected from the group consisting of super highflash naphtha, toluene, xylene, and mixtures thereof; more preferably, super highflash naphtha. Reaction 2, which is accomplished by heating the uncured copolymer, produces the cured, cyclized copolymer (II) and may be carried out either in solution or solid state.

To form a coating solution, the uncured poly(imidazopyrrolone-imide) copolymer, which exists in its polyamic acid form, is mixed with any combination of the above-mentioned polar organic solvents, with or without diluents, in an amount to provide a solids content of from about 5 to about 40%, preferably from about 10 to about 25%, and is then filtered to a low particulate level. At solids contents of less than about 5% or greater than about 40%, difficulties will be encountered in the formation of films of optimal thicknesses and integrity.

The percentage solids present in the coating solution is determined by weighing approximately 2.0 g of solution in a 60 mm Petri dish containing 5 g of sand having a particle size of about 0,4 to 0.6 mm (30-40 mesh standard Ottawa sand) and heating 2-1/2 hours at 200°C in a forced air oven. The sample is then cooled to ambient temperature in a dessicator and weighed to the nearest 0.1 mg. The percentage solids is one hundred times the quotient of the weight of the sample after drying dividided by the weight of the sample before drying.

The coating solution has a viscosity of from about 0.2 to 3.5 Pa·s, preferably from about 0.4 to 0.9 Pa·s, as measured at 25°C, using a Brookfield LVT Viscometer (manufactured by Brookfield Engineering Laboratories, Stoughton, Massachusetts) with an LV-18 spindle at a spindle speed of 1.5 to 6 rpm. The viscosity is critical to the formation of films of the desired thicknesses due to the method of formation of these films, which involves flooding the exposed surface on the wafer to be coated with the solution, and then spinning the wafer to uniformly distribute the solution over the surface and form a film of uniform thickness. At lower viscosities, the solution will not be sufficiently retained on the surface and at higher viscosities, the solution will not be uniformly distributed across the surface.

The coating solutions have a maximum particle size of about 0.2 micron, that is, the solutions are free of particulate matter having a particle size in excess of the maximum particle size. The thicknesses of the cured films formed from the solutions are typically in the range of from about 0.5 to about 2.5 microns. Incorporation in the solutions of particle sizes in excess of 0.2 micron can lead to the formation of pinholes or other such discontinuities, and to irregularities which reduce the degree of planarization of the surface.

The mobile ion content of the coating solutions, measured as sodium ion content, is less than about 5 ppm. Sodium ion contents of up to about 10 ppm can be tolerated but it is preferred that the sodium ion content be maintained below about 5 ppm, preferably at about 3 ppm. The sodium ion content of the solutions and films is determined using a Perkin-Elmer 306 Atomic Absorption Spectrophotometer fitted with a sodium hollow cathode lamp. The sample is heated to 200°C in a porcelain crucible in a fume hood and the residue ashed using a Meeker burner. The ashed residue is dissolved in 0.5 ml reagent grade nitric acid and diluted to 10 ml with deionized water containing less than 0.1 ppm sodium. The sodium ion content is measured against a 1 ppm sodium standard and the sodium ion value is calculated as ten times the quotient of the ratio of the absorbance of the sample over the absorbance of the 1 ppm sodium standard divided by the sample weight in grams.

The method of forming the films of the present invention is preferably practiced by flooding the exposed surface of a wafer with a coating solution of the present invention in an amount of from

about 1 to about 10 ml, preferably about 2 ml per about 20 $cm^2$ (3 square inches) of wafer surface area, and then spinning the wafer to uniformly distribute the solution over the surface at a substantially uniform thickness. The film of coating solution is then dried to remove the solvent and is preferably heated to cure the copolymer.

The wafer, which is typically a silicon wafer, contains at least one semi-conductor element and has on the surface of the silicon a metal, such as aluminum, tungsten, or titanium, in a predetermined pattern forming an interconnection conductor layer. This layer may optionally be covered with a non-conducting layer of $SiO_2$, preferably at a thickness of from about 0.6 to about 0.8 microns, before application of the film. The $SiO_2$ layer is applied by chemical vapor deposition, RF-sputtering or another such process typically employed in the art. Thus, the substrate to which the coating solution is applied may be $SiO_2$, when a layer of this material is present, or a combination of the metal conductor and the silicon that is exposed in those areas not covered by the pattern in which the metal conductor has been applied to the silicon. In instances where the coating solution is applied to a subsequent interconnection conductor layer, the substrate will be the metal and, in those areas not covered by the pattern, the film.

The interconnection pattern is raised above the surface of the underlying silicon and thus when the coating solution flows over the substrate it will tend to be raised in those areas covering the interconnection pattern relative to those areas covering the underlying material. The more uniform the surface of the resulting film, the higher the degree of planarization, and the more suitable the film for use in constructing subsequent interconnection conductor layers in the manufacture of multi-layer semicondutor devices. In complex semi-conductor integrated circuit devices, there may be up to about eight interconnection conductor layers spaced apart by intermediate layers of the passivating film formed by applying and drying a solution of the present invention. Thus, the degree of planarity is preferably high in order to reduce the degree of irregularity of the surface on which the metal is deposited, which irregularity becomes more pronounced with each successive layer. The present invention also contemplates within its scope a multi-layer, semi-conductor device comprising a silicon wafer containing at least one semi-conductor element, an interconnection conductor layer on the surface of the silicon wafer, and a thermally stable, dielectric layer on the interconnection conductor layer, wherein the dielectric layer is the poly(imidazopyrrolone-imide) copolymer film.

Once the coating solution is deposited on the surface as a static flood, the wafer is spun at from about 1000 to about 7000 rpm, preferably from about 3000 to about 6000 rpm, for up to about 1 minute, preferably for from about 30 seconds to about 1 minute, so that the solution is uniformly distributed over the surface resulting in a cured film thickness within the range of from about 0.5 to about 2.5 microns, preferably from about 1 to about 2 microns. The rate of rotation of the wafer and the total rotation time are selected in conjunction with the viscosity and solids content of the coating solution employed in order to form a film of the desired thickness. The method is practiced employing conventional equipment known to those skilled in the art such as a Headway Spinner, manufactured by Headway Research, Inc.

The solvent is removed to form the film by drying and the copolymer is cured by heating, either in air or in an inert atmosphere such as nitrogen.

In order to accelerate the formation of the film, the wafer is preferably dried at a temperature within the range of from about 100° to about 200°C for up to about 2 hours, preferably from about 110° to about 140°C for from about 30 to about 45 minutes and the copolymer is then cured by heating the film at a temperature within the range of from about 150° to about 450°C for up to 2 hours, preferably from about 250° to about 350°C for up to about 1 hour. More preferably, the solvent is removed by baking the coated wafer for about 30 minutes at about 125°C in a convection oven under a nitrogen atmosphere and the copolymer is then cured by heating for about 1 hour at about 300°C, also under a nitrogen atmosphere, on a hot plate.

Regardless of the optional application of a $SiO_2$ layer before applying the coating solution, the surface to be coated may first be treated by applying an adhesion promoter selected from the group consisting of aminosilanes and metal chelates. The adhesion promoter is preferably applied as a solution, in the same manner as the coating solution, by flooding the wafer with from about 1 to about 2 ml of the adhesion promoter solution and then spinning the wafer to evenly distribute the solution. Preferably, the wafer is spun for a few seconds at about 500 rpm followed by spinning at about 5000 to about 7000 rpm to set the final film thickness. The adhesion promoter is then dried, preferably in air, before applying the coating solution. If desired, the metal surface may be subjected to a plasma pretreatment by controlled oxidation of the metal surface in order to promote adhesion of the coating solution. Plasma processing of the metal, which is in the zero oxidation state, etches the metal and is less desirable than the use of an adhesion promoter.

The thermally stable, dielectric films of the present invention are films of the cured poly(imidazopyrrolone-imide) copolymer, as the cured copolymer is defined in connection with the coating solutions of the present invention. The films can be etched in oxygen-plasma with an etch time acceptable for production processing. The films of the cured copolymer, when employed as a passivating layer on or between interconnection conductor layers, are characterized by a thickness within the range of from about 0.5 to about 2.5 microns, preferably from about 1 to about 2 microns, a mobile ion content, measured as sodium ion content, of less than about 5 ppm, a degree of planarization between about 0.3 and 0.8, preferably between about 0.6 and 0.8, and an electrical resistance of from about $10^{12}$ to about $10^{16}$ ohm-cm, preferably from about $10^{15}$ to about $10^{16}$ ohm-cm. The films of the cured copolymer have a dissipation factor between about 0.001 and about 0.02 at 300 $KH_z$, preferably between about 0.007 and about 0.009.

The degree of planarization of the film is equal to 1 minus the quotient of the height to which the film is raised over the interconnection conductor relative to the surface of the film that is not over the conductor, divided by the thickness of the interconnection conductor. The planarity measurements can be made using a Taylor-Hobson Talystep or by scanning electron microscopy. The degree of planarization depends to some extent, all other parameters being equal, on the thickness of the film, with the degree of planarization approaching unity as the thickness of the film increases.

The uncured or cured films of the present invention can be overcoated with a photoresist, exposed, and developed to yield a patterned multilayer structure.

The films of the cured copolymer are essentially water impermeable and thus also find use as a final barrier layer in the construction of semiconductor devices in order to prevent the entry of moisture that can lead to short circuits.

Accordingly, the present invention also contemplates within its scope a semi-conductor device comprising a silicon wafer containing at least one semi-conductor element, a ceramic coating enclosing the wafer, and an external coating enclosing the ceramic coating, in which the external coating is a film of the cured poly(imidazopyrrolone-imide) copolymer. This external coating preferably has a thickness of from about 0.5 to about 40 microns.

The films of the poly(imidazopyrrolone-imide) copolymer may also be applied on top of the last interconnection conductor layer before the ceramic cover or coating is applied in order to prevent alpha particles released by the ceramic material from penetrating the semi-conductor.

The following examples present illustrative but non-limiting embodiments of the present invention.

## Examples

In examples 1, 2 and 3, the synthesis of the copolymer was carried out in a 500 ml resin kettle fitted with a nitrogen inlet tube, stirrer, thermometer, addition neck, and 10 ml bulb pipet. The pipet was fitted at its bottom end with a polypropylene tube which could be submerged in the reaction mixture for viscosity readings and fitted at its top end with a 3-way stopcock. The resin kettle was flushed with nitrogen before use.

Viscosity measurements were made during the course of the BTDA additions as follows. Stirring was stopped and the polypropylene tubing was lowered into the reaction mixture. Enough reaction mixture

was drawn into the pipet so as to exceed the graduation on the upper part of the pipet. The stopcock was then turned to the seal position and the tubing was lifted out of the reaction mixture and allowed to drain. The upper verticle inlet of the 3-way stopcock was fitted with a 2-way stopcock which in turn was connected to a balloon filled with nitrogen. By placing a finger over the horizontal inlet of the 3-way stopcock, the baloon was evacuated until it became limp and crinkled when held horizontally. The 3-way stopcock was then opened by turning counterclockwise and the efflux time of the mixture was measured using a stopwatch. The efflux time was correlated with the viscosity of the reaction solution in Pa·s.

Example 1

All the glassware used in this example was dried in an oven and allowed to equilibrate to room temperature prior to use. 10.58 g (0.05282 mole) of ODA and 3.78 g (0.0176 mole) of TAB were added to the 500 ml resin kettle, followed by addition of 100 ml of NMP. A solution of 20.46 g of BTDA dissolved in 125 ml of NMP was added to the kettle with constant stirring over a period of 30 minutes. Next, a solution of 3.41 g of BTDA in 38 ml of NMP was added over about seven hours.

The final viscosity was adjusted with 2.5 ml of a solution of 1.14g of BTDA in 13g of NMP added over about one hour. The reaction viscosity was 0.7 Pa·s after standing for 16 hours at ambient temperature. The solution had a solids content of approximately 13% and a sodium ion content of 0.2 ppm.

An aliquot of the solution was spread on a glass plate with a 0.02 cm (0.003-inch) Bird coating bar and heated for 30 minutes at 125°C in a nitrogen atmosphere. The sample was cured by heating for one

hour at 300°C on a hot plate, also in a nitrogen atmosphere. A sample of the film was submitted for thermal gravimetric analysis and the results are summarized in Table 1.

A sample of the reaction mixture was diluted to about 11% solids and filtered to 5.0 microns. Two 5.08 cm (2-inch) silicon wafers that had been previously coated with an adhesion promoter (VM651, 0.1%), were each flooded with 2 ml of the sample and spun at 5000 rpm for 30 seconds. The wafers were baked at from 125° to 140°C for 30 minutes in a convection oven, followed by heating at 300°C for 1 hour on a hot plate. The resulting films had thicknesses from 0.82 to 0.95 microns.

Example 2

12.85 g (0.0636 mole) of ODA and 1.51 g (0.007 mole) of TAB were dissolved in 100 ml of NMP contained in a 500 ml resin kettle. Approximately one hour later, 21.60 g of BTDA dissolved in 138 ml of NMP were added to the resin kettle with constant stirring over 36 minutes while the temperature was maintained between 22 and 25°C. A solution of 2.28g of BTDA in 26 ml of NMP was then added in 3 ml portions at 1/2 hour intervals over a period of 4 hours.

The reaction mixture had a viscosity of 0.618 Pa·s at 25°C twenty-four hours after the last addition of BTDA. The solution had a sodium ion content of 0.7 ppm and a solids content of about 14%.

Example 3

10.58 g (0.05292 mole) of ODA and 3.78 g (0.0176 mole) of TAB were added to a 500 ml resin kettle under a flow of nitrogen, followed by addition of 125 ml of NMP. 20.46 g of BTDA were then dissolved in 100 ml of NMP yielding a clear dark

yellow solution. The BTDA solution was added to the reaction vessel using a 250 ml dropping funnel over a 1-hour period while maintaining the reaction temperature between 20 and 21°C using a water bath. 3.0 g of BTDA were then added to the reaction mixture over a period of 8 hours from a 60 ml dropping funnel in sixteen aliquots of 1 to 4 ml each. The BTDA was prepared as a solution of 3.4 g BTDA in about 40 g NMP.

The viscosity of the final solution measured at room temperature five days after synthesis was 3.450 Pa·s, and at -4°C the viscosity was 0.65 Pa·s. The solution had a solids content of 13% and a sodium ion content of 0.11 ppm.

Example 4

1.50 g (0.007 mole) of TAB and 4.20 g (0.021 mole) of ODA were dissolved in 42 ml of NMP. 9.02 g (0.028 mole) of BTDA dissolved in 49 ml of NMP were then added, over a five minute period, to the resin kettle producing a reaction mixture having a viscosity of 0.49 Pa·s.

The product was isolated by precipitation in 300 ml of a 2:1 (v/v) solution of deionized water and ethanol. The resulting solid was filtered and triturated three times with 75 ml portions of the precipitating solution and dried to a constant weight of 10.3 g. The solid had a sodium ion content of 4.4 ppm.

A solution of 20% solids was obtained by dissolving 3 g of the solid product in 12 g of an 80:20 (w/w) solution of NMP and super highflash naphtha. A sample of the solution was spread on a glass plate with a 0.02 cm Bird coating bar and the plate was heated for 45 minutes in a convection oven at 100 to 125°C under a nitrogen atmosphere, followed by heating on a hot plate at 290°C, also

under nitrogen atmosphere. The cured film was subjected to thermal gravimetric analysis and the results are summarized in Table I.

## Table 1

Weight Of Sample Remaining At Indicated Temperature (% Of Initial Weight)

| Temp. °C | Example 1 | | Example 2 | | Example 4 | |
|---|---|---|---|---|---|---|
| | $N_2$ | Air | $N_2$ | Air | $N_2$ | Air |
| 30 | 99.5 | 99.5 | 99.8 | 100.0 | 100.0 | 100.00 |
| 300 | 98.0 | 98.0 | 98.3 | 99.5 | 98.5 | 98.5 |
| 350 | 98.0 | 98.0 | 98.0 | 93.3 | 98.0 | 98.5 |
| 400 | 98.0 | 98.0 | 97.8 | 99.0 | 98.0 | 98.5 |
| 450 | 97.0 | 97.0 | 97.3 | 98.2 | 97.0 | 98.0 |
| 500 | 96.0 | 94.0 | 95.5 | 95.0 | 96.0 | 95.5 |
| 550 | 91.0 | 70.5 | 89.9 | 75.0 | 91.0 | 80.0 |
| 600 | 75.5 | 1.5 | 71.0 | 2.0 | 69.0 | 0.0 |
| 650 | 36.5 | 0.0 | 25.0 | 0.0 | 10.5 | 0.0 |
| 700 | 7.5 | 0.0 | 0.0 | 0.0 | 0.0 | 0.0 |

Example 5

To a suitable reaction vessel, was added a solution of 4.20 g (0.021 mole) of ODA and 1.50 g (0.007 mole) of TAB in 90 g of NMP, followed by addition, within a 5-minute interval, of a solution of 6.45 g (0.028 mole) of pyromellitic dianhydride (PMDA) in 110 g of NMP. After 1.5 hours, the resulting product was isolated at ambient temperature by pouring the 200 ml mixture, in 100 ml portions, into two bottles each containing 300 ml of a 2:1 (v/v) solution of deionized water and ethanol. The mixture in each bottle was then filtered slowly using #41 and #1 filter paper and the resulting mass was triturated with 75 ml of the deionized water and ethanol solution and filtered. The solid was washed with the deionized water and ethanol solution and filtered two more times. The product was then dried under high vacuum in the presence of $P_2O_5$ to yield 7 g of solid.

3.0 g of the resulting solid were then added to 12 g of an 80:20 (w/w) solution of NMP and super highflash naphtha to yield a solution having a viscosity of 0.54 Pa·s and a solids content of 20%. Two wafers, which had previously been coated with an adhesion promoter (VM651, 0.1%), were then flooded with 2 ml each of the solution, spun at 5000 rpm for 30 seconds, dried at from 120° to 125°C for 30 minutes under a flow of nitrogen to yield a film thickness of about 1.4 microns, and then heated at 300°C for 1 hour, also under a flow of nitrogen, to yield cured films each having a thickness of about 0.95 micron.

A sample of the copolymer was cured as described in example 1. The cured film was then removed from the glass plate using a razor blade and subjected to thermal gravimetric analysis. The results

are summarized in Table 2. The cured film had a sodium ion content of 3.2 ppm.

Table 2

Weight Of Sample Remaining At Indicated Temperature (% Of Initial Weight)

| Temp. °C | $N_2$ | Air |
|---|---|---|
| 30 | 100.0 | 100.0 |
| 300 | 98.5 | 98.5 |
| 350 | 98.0 | 98.0 |
| 400 | 98.0 | 98.0 |
| 450 | 97.0 | 97.0 |
| 500 | 96.0 | 93.5 |
| 550 | 91.5 | 78.0 |
| 600 | 77.0 | 5.0 |
| 650 | 42.5 | 0.0 |
| 700 | 13.0 | 0.0 |

CLAIMS:

1. A coating solution for use in forming planar, thermally stable, dielectric films having a low mobile ion content, comprising a solution of an uncured poly(imidazopyrrolone-imide) copolymer that is the reaction product of a tetracarboxylic compound selected from the group consisting of

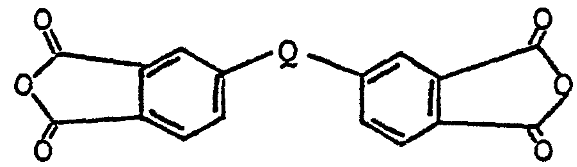 , 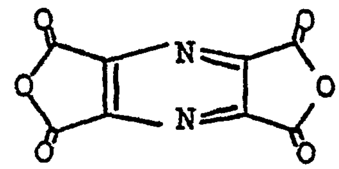 ,

and mixtures thereof; an aromatic tetraamine compound having the following formula:

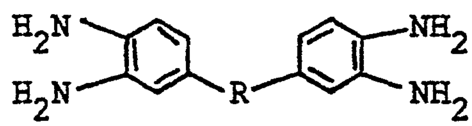 ;

and a diamine compound selected from the group consisting of

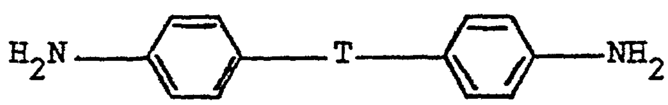 , 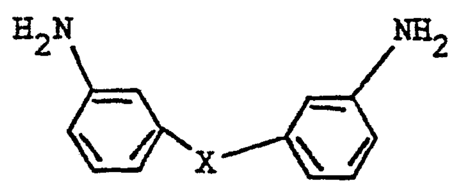 ,

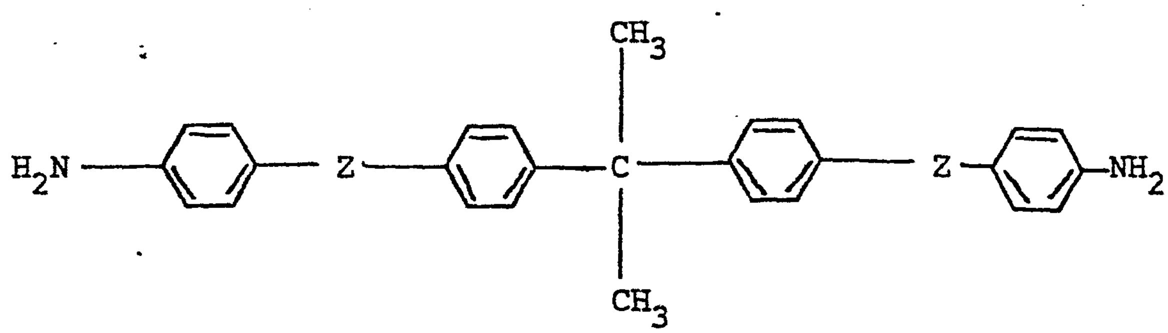

and mixtures thereof, wherein Q and R are, independently, a direct bond, -O-, -CO-, -S-, $-SO_2-$, or $-NCH_3-$; T is a direct bond, -O-, -S-, -SO-, $-SO_2-$, or

$-NCH_3-$; and X and Z are, independently, a direct bond, -O-, -S-, -SO-, $-SO_2-$, -CO-, or $-NCH_3-$; in a solvent selected from the group consisting of 1-methyl-2-pyrrolidinone, N,N-dimethylacetamide, N,N-dimethylformamide, dimethylsulfoxide, and mixtures thereof; the poly(imidazopyrrolone-imide) copolymer having an inherent viscosity of at least about 0.1 dl/g as a 0.1 g in 20 ml solution in 1-methyl-2-pyrrolidinone at 25°C; and the solution having a viscosity of from about 0.2 to 3.5 Pa·s,

a sodium ion content of less than about 5 ppm, a solids content of from about 5 to about 40%, and a maximum particle size of about 0.2 micron.

2. The coating solution of claim 1 wherein the solvent includes a diluent selected from the group consisting of super highflash naptha, toluene, xylene, and mixtures thereof.

3. The solution of claim 1 wherein the poly(imidazopyrrolone-imide) copolymer is the reaction product of 3,3',4,4'-benzophenonetetracarboxylicdianhydride, 3,3',4,4'-tetraaminobiphenyl, and 4,4'-oxydianiline.

4. The solution of claim 3 wherein the solids content is within the range of from about 10 to about 25%.

5. The solution of claim 4 wherein the sodium ion content is within the range of from about 3 to about 5 ppm.

6. The solution of claim 4 wherein the viscosity of the solution is within the range of from about 0.2 to 3.5 Pa·s.

7. The solution of claim 3 wherein the solvent is 1-methyl-2-pyrrolidinone.

8. The solution of claim 3 wherein the solvent is N,N-dimethylacetamide.

9. A method of forming a planar, thermally stable, dielectric film having a low mobile

ion content on the exposed surface of an interconnection conductor layer on a silicon wafer containing at least one semi-conductor element, comprising applying the solution of claim 1 or 3 to the exposed surface of the interconnection conductor layer in an amount of from about 1 to about 10 ml per about 20 $cm^2$ of wafer surface area, then spinning the wafer at from about 1000 to about 7000 rpm for up to about one minute so that the solution is uniformly distributed over the interconnection conductor layer at a thickness within the range of from about 0.5 to about 2.5 microns, removing the solvent from the solution, and then curing the copolymer, whereby a planar, thermally stable, insulating film having a low mobile ion content and a thickness within the range of from 0.5 to 2.5 microns is formed on the conductor layer.

10. The method of claim 9 wherein the solvent is removed by drying at a temperature within the range of from about 100 to about 200°C for up to about 2 hours.

11. The method of claim 10 wherein the solvent is removed by drying for about 30 minutes at about 125°C.

12. The method of claim 9 wherein the copolymer is cured by heating at a temperature within the range of from about 150° to about 450°C for up to about 2 hours.

13. The method of claim 12 wherein the copolymer is cured by heating at from about 250° to about 350°C for up to about 1 hour.

14. The method of claim 9 including first applying to the exposed surface of the interconnection layer an adhesion promoter selected from the group consisting of metal chelates and aminosilanes.

15. The method of claim 9 including first applying to the exposed surface of the interconnec-

tion layer $SiO_2$ at a thickness of from about 6000 to about 8000 Å.

16. A thermally stable, dielectric film for use as a passivating layer in the manufacture of semi-conductor integrated circuits, comprising a film of a cured poly(imidazopyrrolone-imide) copolymer, wherein the uncured copolymer is the reaction product of a tetracarboxylic compound selected from the group consisting of

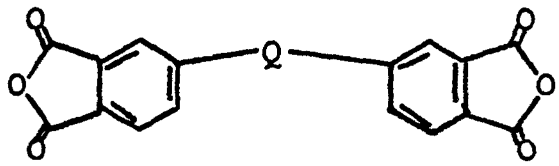 , 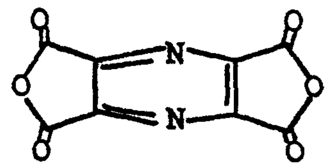 ,

and mixtures thereof; an aromatic tetraamine compound having the following formula:

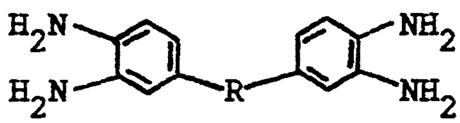 ;

and (C) a diamine compound selected from the group consisting of

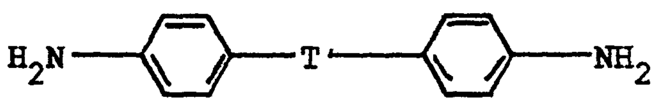 , 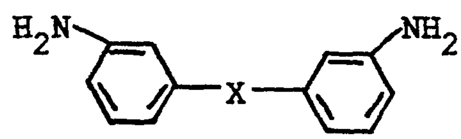 ,

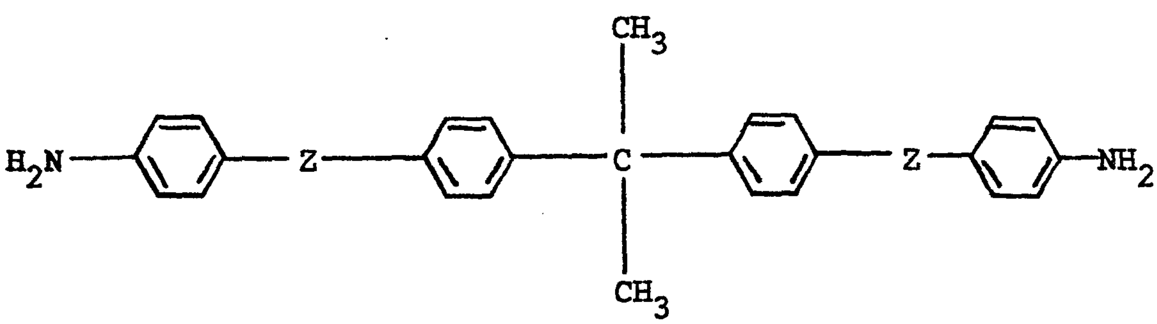 ,

and mixtures thereof, wherein Q and R are, independently, a direct bond, -O-, -CO-, -S-, $-SO_2-$, or $-NCH_3-$; T is a direct bond, -O-, -S-, -SO-, $-SO_2-$ or

$-NCH_3-$; and X and Z are, independently, a direct bond, -O-, -S-, -SO-, $-SO_2-$, -CO- or $-NCH_3-$; the uncured copolymer having an inherent viscosity of at least about 0.1 dl/g as a 0.1 g in 20 ml solution in 1-methyl-2-pyrrolidinone at 25°C; and the cured copolymer film having a thickness within the range of from about 0.5 to about 2.5 microns, a sodium ion content of less than about 5 ppm, a degree of planarization between about 0.3 and about 0.8, and an electrical resistance of from about $10^{12}$ to about $10^{16}$ ohm-cm.

17. The film of claim 16 wherein the uncured poly(imidazopyrrolone-imide) copolymer is the reaction product of 3,3',4,4'-benzophenonetetracarboxylic-dianhydride, 3,3',4,4'-tetraminobiphenyl, and 4,4'-oxydianiline.

18. The film of claim 16 or 17 wherein the thickness is from about 0.5 to about 2.5 microns.

19. A multi-layer semi-conductor device, comprising a silicon wafer containing at least one semiconductor element, an interconnection conductor layer on the surface of the silicon wafer, and a thermally stable, dielectric layer on the interconnection conductor layer, the dielectric layer comprising a film of a cured poly(imidazopyrrolone-imide) copolymer.

20. A semi-conductor device, comprising a silicon wafer containing at least one semi-conductor element, a ceramic coating enclosing the wafer, and an external coating enclosing the ceramic coating, the external coating comprising a film of a cured poly(imidazopyrrolone-imide) copolymer.

21. The semi-conductor device of claim 20 wherein the external coating has a thickness of from about 0.5 to about 40 microns.